Europäisches Patentamt

European Patent Office

Office européen des brevets

(11) Veröffentlichungsnummer: **0 498 936 B1**

(12) **EUROPÄISCHE PATENTSCHRIFT**

(45) Veröffentlichungstag der Patentschrift: **25.01.95**

(51) Int. Cl.6: **B23K 20/10**

(21) Anmeldenummer: **91119407.4**

(22) Anmeldetag: **14.11.91**

(54) **Verfahren und Einrichtung zur Messung der Schwingungsamplitude an einem Energietransducer.**

(30) Priorität: **15.02.91 CH 471/91**

(43) Veröffentlichungstag der Anmeldung:
**19.08.92 Patentblatt 92/34**

(45) Bekanntmachung des Hinweises auf die
Patenterteilung:
**25.01.95 Patentblatt 95/04**

(84) Benannte Vertragsstaaten:
**AT BE CH DE DK ES FR GB GR IT LI LU NL SE**

(56) Entgegenhaltungen:
**EP-A- 0 275 877**
**EP-A- 0 317 787**
**EP-A- 0 340 506**
**EP-A- 0 342 358**
**US-A- 4 040 885**

**WIRE AND WIRE PRODUCTS Bd. 43, Nr. 1, 1. Januar 1973, SOMMERSET US Seite 67;'Reflected light and sound used in ultrasonic welding of wire'**

(73) Patentinhaber: **ESEC SA**
**Hinterbergstrasse 32**
**CH-6330 Cham (CH)**

(72) Erfinder: **Felber, Armin**
**Meyerstrasse 22**
**CH-6003 Luzern (CH)**
Erfinder: **Nehls, Walter**
**Sonnheimstrasse 3**
**CH-6044 Udligenswil (CH)**

(74) Vertreter: **EGLI-EUROPEAN PATENT ATTORNEYS**
**Horneggstrasse 4**
**Postfach 473**
**CH-8034 Zürich (CH)**

**Beschreibung**

Die Erfindung betrifft ein Verfahren zur Messung der Schwingungsamplitude an einem Energietransducer, welcher zusammen mit einer entsprechend ausgebildeten Bondkopf-Vorrichtung zur Ultraschall kontaktierenden Drahtverbindung von elektrischen Schaltungen an metallenen Systemträgern dem jeweiligen Prozesspunkt zugestellt und zur Erzeugung einer mechanischen Longitudinal-Schwingung mit einem eingegebenen, ersten Ultraschallwert zur Erzeugung einer elektrischen Spannung beaufschlagt wird, wobei die momentane Amplitude der Longitudinal-Schwingung des Energietransducers gemessen wird. Die Erfindung betrifft ausserdem eine Einrichtung gemäß dem Oberbegriff des Anspruchs 7. Ein solches Verfahren und eine solche Einrichtung sind bekannt, z.B. aus der EP-A-275877.

Bei der Herstellung von Halbleiterchips erfolgt das Bonden des Drahtes mittels dem an sich bekannten Thermosonic-Prozess, bei welchem einer an dem einen, vorderen Ende eines Transducers angeordneten und den Draht führenden Kapillare die erforderliche und auf die Kontaktstelle zu übertragende Ultraschall-Energie für die Drahtverschweissung zugeführt wird. Die Übertragung der Ultraschall-Energie ist dabei von verschiedenen Einflussfaktoren, beispielsweise von mechanischen Veränderungen abhängig, welche insbesondere beim Einspannen des Transducers entstehen. Weitere, das Bonden beeinflussende Faktoren bestehen darin, dass die Kapillare aufgrund der Abnutzung auswechselbar an der Halterung zu befestigen ist, und dass bei der Montage sowie durch geringfügige, beispielsweise herstellungsabhängige Abweichungen der neu einzusetzenden Kapillare das Bonden beeinflussende Faktoren entstehen.

Die vorliegende Erfindung befasst sich mit dem Problem der Messung der Schwingungsamplitude an der Kapillarenspitze eines zum Bonden von elektrischen Schaltungen ausgebildeten Energietransducers, wobei der Erfindung die Aufgabe zugrunde liegt, ein Verfahren sowie eine Einrichtung zur Durchführung des Verfahrens anzugeben, mittels welchem/welcher die absolute Zustellbewegung der Bondkopf-Vorrichtung sowie die absolute Longitudinal-Schwingung, welche je anhand vorbestimmter Faktoren erreicht wird, entsprechend gemessen und das Messergebnis zur Bestimmung einer den jeweiligen Anforderungen entsprechenden Ultraschall-Energie herangezogen wird.

Diese Aufgabe wird erfindungsgemäss durch das Verfahren mit den Merkmalen des kennzeichnenden Teils des ersten Patentanspruchs gelöst.

Die erfindungsgemässe Einrichtung zur Durchführung des Verfahrens besteht aus einem Trägerelement mit einer Auflageplatte für einen metallenen Systemträger und einer BondkopfVorrichtung, welche zusammen mit dem daran angeordneten Energietransducer zum Bonden elektrischer Schaltungen dem jeweiligen Prozesspunkt des Systemträgers zustellbar ist, wobei die Einrichtung dadurch gekennzeichnet ist, dass ein entsprechend angeordneter und mit einem Rechner in Wirkverbindung stehender Messkopf mit mindestens einem optisch/elektrischen Sensor vorgesehen ist, und dass der Sensor einen optischen Wirkungsbereich aufweist, mit welchem sowohl eine Wegstrecke für die Zustellbewegung der Bondkopf-Vorrichtung als auch eine Messgrösse für die Longitudinal-Schwingung des Energietransducers erfassbar und mit den Messwerten der Rechner aktivierbar ist.

Weitere Merkmale der Erfindung ergeben sich aus der folgenden Beschreibung in Verbindung mit der Zeichnung und den weiteren Patentansprüchen.

Die Erfindung wird nachstehend anhand der Zeichnung beschrieben. Es zeigt:

Fig.1     eine in schematisch, perspektivischer Ansicht dargestellte Einrichtung zur Ultraschall kontaktierenden Drahtverbindung von Schaltkreisen an elektronischen Komponenten, und

Fig.2     eine als Blockschaltbild dargestellte Ablaufsteuerung für die Einrichtung gemäss Fig.1.

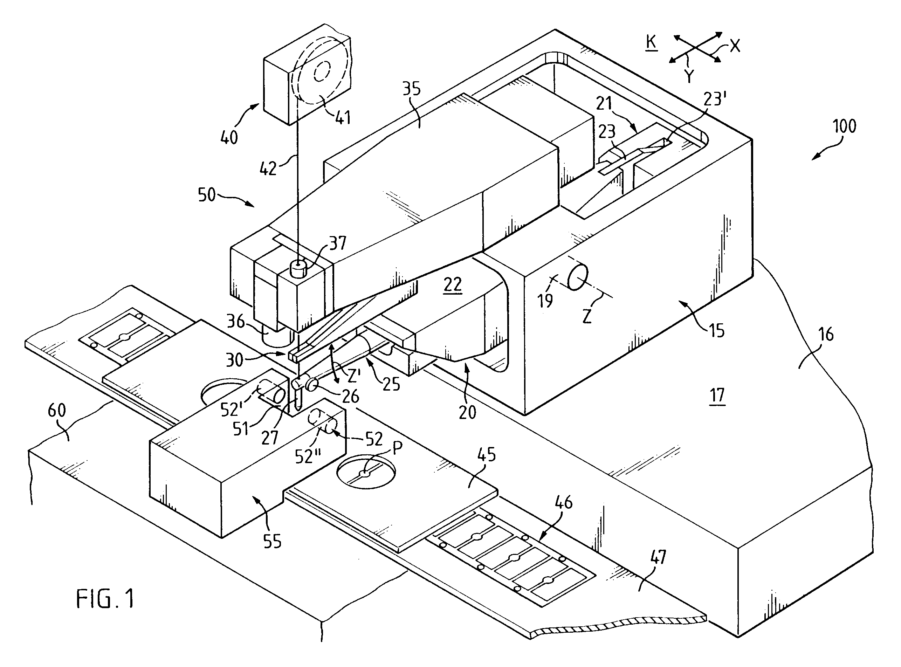

Zur Verdeutlichung der Erfindung und als allgemeine Systemübersicht ist in Fig.1 eine in schematisch, perspektivischer Ansicht dargestellte Einrichtung 100 der Halbleiter-Verbindungstechnik dargestellt. Die Einrichtung 100 dient zur Ultraschall kontaktierenden Drahtverbindung von Schaltungen an elektronischen Komponenten und umfasst im wesentlichen eine Bondkopf-Vorrichtung 50, ein Kontaktierorgan 20 mit entsprechend zugeordneter Bonddraht-Klemmvorrichtung 30 sowie eine schematisch dargestellte Bonddraht-Zuführvorrichtung 40.

Weiterhin erkennt man in Fig.1 eine Halteplatte 45 einer nicht dargestellten Niederhalter-Vorrichtung mit welcher ein metallener Systemträger 46 (leadframe strip) mit dem jeweiligen Prozesspunkt P exakt ausgerichtet auf einer Auflageplatte 47 lagestabil gehalten wird. Dem Kontaktierorgan 20 ist ein mit einer Ausnehmung 51 versehener Messkopf 55 zugeordnet, welcher mittels einer nicht näher dargestellten Schraubverbindung oder dergleichen feststehend an einem Trägerelement 60 der Einrichtung 100 befestigt ist.

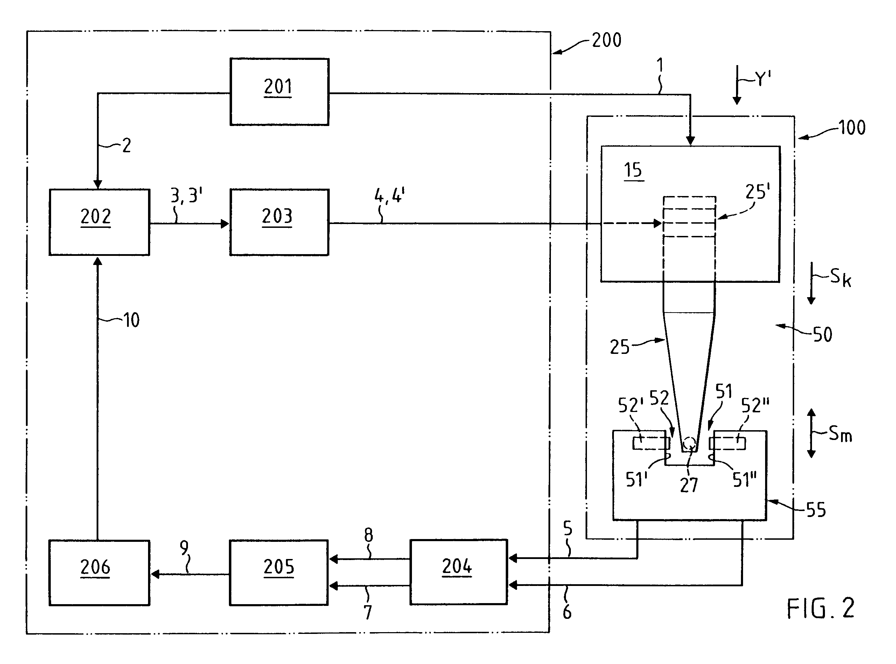

Zwischen den beiden im Abstand zueinander angeordneten Wänden 51',51'' (Fig.2) der Ausnehmung 51 des Messkopfes 55 ist eine Kapillare 27 eines mit dem Kontaktierorgan 20 in Wirkverbindung stehenden Energietransducers 25 angeordnet. Das Kontaktierorgan 20 ist zusammen mit dem Energietransducer 25 um eine Achse Z in Pfeilrichtung Z' schwenkbar (Fig.1). Der Energietransducer 25 wird in der nachfolgenden Beschreibung aus Gründen der Einfachheit als Transducer 25 bezeichnet.

In dem Messkopf 55 ist weiterhin ein in der Gesamtheit mit 52 bezeichneter Sensor, beispielsweise ein optisch/elektronisch arbeitender Sensor 52 angeordnet. Der Sensor 52 umfasst im wesentlichen ein Senderteil 52' und ein korrespondierend dazu angeordnetes Empfängerteil 52''. Der optische Wirkungs- oder Messbereich des Sensors 52 ist derart dimensioniert, dass dieser sowohl die Wegstrecke der Zustellbewegung des Bondkopfes als auch eine Messgrösse der Longitudinal-Schwingung des Transducers 25 erfasst. Die Wegstrecke der Zustellbewegung entspricht dabei einem mehrfachen, beispielsweise einem zehnfachen der Ultraschallamplitude der Kapillare 27. Mit dem feststehend an dem als Maschinenbasis ausgebildeten Trägerelement 60 angeordneten Messkopf 55 wird die Relativbewegung (Longitudinal-Schwingung) der Kapillare 27 gemessen.

Die einzelnen, miteinander in Wirkverbindung stehenden Elemente der in Fig.1 dargestellten Einrichtung 100 werden nachstehend beschrieben:

Die Bondkopf-Vorrichtung 50 umfasst im wesentlichen ein gehäuseartig ausgebildetes Trägerelement 15. Das Trägerelement 15 ist mittels entsprechend angeordneter, nicht dargestellter Antriebe gemäss einem mit K bezeichneten Koordinatensystem in der Ebene in X-Richtung und/oder Y-Richtung verstellbar. Das Trägerelement 15 ist auf der einen, einer Gleitplatte 16 zugewandten Seite mit einem nicht näher dargestellten, vakuumvorspannbaren Luftkissenlager versehen, wodurch das Trägerelement 15 auf der Gleitfläche 17 der Gleitplatte 16 etwa frei schwebend beweglich gelagert ist. Das Trägerelement 15 dient zur Aufnahme und Lagerung des Kontaktierorgans 20 sowie eines Auslegers 35. An dem einen, vorderen Ende des Auslegers 35 ist ein entsprechend ausgebildetes Bonddraht-Führungsorgan 37 sowie ein optisches Abtastelement 36 (Sensor) angeordnet, welches auf den jeweiligen Prozesspunkt P des Systemträgers 46 ausgerichtet wird. Durch eine entsprechende Gleichstrom-Erregung der nicht dargestellten und mit dem Trägerelement 15 in Wirkverbindung stehenden Antriebe wird die in X-Richtung und/oder in Y-Richtung orientierte Bewegung des Trägerelements 15 erreicht.

Ein bevorzugtes und entsprechend ausgebildetes Ausführungsbeispiel der erwähnten Bondkopf-Vorrichtung 50 ist aus der EP-A 0 317 787 bekannt.

Das vorstehend beschriebene Trägerelement 15 dient zur Aufnahme des in der Gesamtheit mit 20 bezeichneten Kontaktierorgans. Das Kontaktierorgan 20 umfasst im wesentlichen einen Tragrahmen 22, welcher um die Achse Z eines in dem Trägerelement 15 gelagerten Achskörpers 19 in Pfeilrichtung Z' schwenkbar ist. Der Tragrahmen 22 ist im vorderen Bereich zur Lagerung des in der Gesamtheit mit 25 bezeichneten Transducers sowie der daran gelagerten Bonddraht-Klemmvorrichtung 30 ausgebildet. An dem vorderen Ende des Transducers 25 ist die Kapillare 27 vorgesehen, welche durch eine entsprechend ausgebildete Schraubverbindung 26 auswechselbar am Transducer 25 gehalten und befestigt ist. An dem anderen, hinteren Ende des Tragrahmens 22 ist ein in der Gesamtheit mit 21 bezeichneter, elektromotorischer Antrieb vorgesehen, welcher im Abstand zueinander angeordnete, nicht näher bezeichnete Stator- und Spulenkörper umfasst. Zwischen den Stator- und Spulenkörpern ist in einem Spalt 23' ein am Tragrahmen 22 befestigter, schwertartig ausgebildeter Magnetkörper 23 angeordnet. Durch eine entsprechende Gleichstrom-Erregung der Spulenkörper wird eine Relativbewegung des Magnetkörpers 23 zu den Statorkörpern und dadurch die in Pfeilrichtung Z' orientierte Schwenkbewegung (Fig.1) der Elemente 20,25 und 30 erreicht.

Ein bevorzugtes und entsprechend ausgebildetes Ausführungsbeispiel des erwähnten und in der Gesamtheit mit 20 bezeichneten Kontaktierorgans ist aus der EP-A 0 340 506 bekannt.

Weiterhin erkennt man in Fig.1 die schematisch dargestellte Bonddraht-Zuführvorrichtung 40, welche ein nicht näher dargestelltes Abzugselement umfasst, mittels welchem ein von einem hier nicht dargestellten elektrisch/optischen Sensor berührungslos abgetasteter Bonddraht 42 von einer entsprechend gelagerten Drahtspule 41 abgezogen wird. Der Bonddraht 42 wird dabei durch das am Ausleger 35 vorgesehene Führungsorgan 37 hindurchgeführt und im wesentlichen mittels der Klemmvorrichtung 30 von der Drahtspule 41 abgezogen und zentrisch in die Kapillare 27 geführt.

Ein bevorzugtes und entsprechend ausgebildetes Ausführungsbeispiel der vorstehend erwähnten Bonddraht-Zuführvorrichtung 40 ist aus der EP-A 0 342 358 bekannt.

Fig.2 zeigt eine als Blockschaltbild dargestellte Ablaufsteuerung und man erkennt die schematisch dargestellte Bondkopf-Vorrichtung 50 und den Messkopf 55 der Einrichtung 100 sowie einen in der Gesamtheit mit 200 bezeichneten Rechner. Der Rechner 200 umfasst im wesentlichen eine Steuereinheit 201, einen Multiplikator 202, einen Generator 203, einen Verstärker 204, einen ersten Prozessor 205 sowie einen zweiten Prozessor 206.

Die Arbeitsweise der Einrichtung 100 in Verbindung mit dem in Fig.2 dargestellten Rechner 200 für die im wesentlichen aus der Messung der Bewegung der Bondkopf-Vorrichtung 50 und der Messung der Schwingungsamplitude des Transducers 25 sowie der Kalibrierung der einzelnen Messwerte zusammengesetzte Ablaufsteuerung wird nachstehend beschrieben:

- von der Steuereinheit 201 wird dem nicht dargestellten und mit dem Trägerelement 15 in Wirkverbindung stehenden elektromotorischen Antrieb ein entsprechendes Signal 1 zugeführt, wodurch die Bondkopf-Vorrichtung 50 mit dem Transducer 25 um eine vorbestimmte Wegstrecke $S_k$ in Pfeilrichtung Y' bewegt, wobei die fixe Wegstrecke $S_k$ von dem Sensor 52 gemessen wird; ein Signal 5, welches der fixen Wegstrecke $S_k$ entspricht, wird zur Umwandlung in eine entsprechende Spannung $U_k$ dem Verstärker 204 zugeführt, wobei die derart ermittelte erste Spannung $U_k$ entweder abgelesen oder entsprechend gespeichert wird;

- ein vorprogrammierter, erster Ultraschallwert wird von der Steuereinheit 201 als Signal 2 dem Multiplikator 202 zugeführt und von dem Multiplikator mit einem entsprechenden Signal 3 der Generator 203 beaufschlagt; von dem Generator 203 wird das Signal 3 in eine erste, elektrische Spannung umgewandelt und als Signal 4 einem mit dem Transducer 25 wirkverbundenen Schwingungsorgan 25' zugeführt, wodurch an der Kapillare 27 des Transducers 25 eine relativ zum feststehenden Messkopf 55 orientierte, mechanische Longitudinal-Schwingung erzeugt und von dem Sensor 52 als erste Messgrösse $S_m$ gemessen und erfasst wird; ein der ersten Messgrösse $S_m$ (Longitudinal-Schwingung) entsprechendes Signal 6 wird dem Verstärker 204 zugeführt und von diesem in eine entsprechende, zweite Spannung $U_m$ umgewandelt, wobei die derart ermittelte zweite Spannung $U_m$ ebenfalls gespeichert werden kann;

- von dem Verstärker 204 wird die erste Spannung $U_k$ als Signal 7 und die zweite Spannung $U_m$ als Signal 8 dem ersten Prozessor 205 zugeführt und von dem Prozessor 205 wird gemäss der folgenden Gleichung

$$S'_m = S_k \frac{U_m}{U_k}$$

die momentane (tatsächliche) und mit $S'_m$ bezeichnete Ultraschall-Amplitude ermittelt und als Signal 9 dem zweiten Prozessor 206 zugeführt;

- in dem zweiten Prozessor 206 wird die als Signal 9 zugeführte, momentane Ultraschall-Amplitude $S'_m$ als entsprechender Korrekturfaktor $K_f$ umgewandelt und als Signal 10 dem Multiplikator 202 zugeführt;

- in dem Multiplikator 202 wird der von der Steuereinheit 201 als Signal 2 zugeführte erste Ultraschallwert mit dem ermittelten Korrekturfaktor $K_f$ multipliziert und als entsprechend korrigiertes Signal 3' dem Generator 203 zugeführt; wobei

- in dem Generator 203 nunmehr das Signal 3' in eine korrigierte, zweite Spannung umgewandelt und als Signal 4' dem mit dem Transducer 25 wirkverbundenen Schwingungsorgan 25' zugeführt wird.

Mit dem erfindungsgemässen Verfahren und der Einrichtung zur Durchführung des Verfahrens besteht nunmehr die Möglichkeit, die beispielsweise durch einen Austausch der Kapillare oder durch Abnutzung der Kapillare verursachte Änderung der Longitudinal-Schwingung direkt und exakt an der Spitze der vorhandenen Kapillare zu messen und mit dem errechneten Korrekturfaktor den ersten Ultraschallwert entsprechend zu kalibrieren.

Ein besonderer Vorteil wird weiterhin darin gesehen, dass der kalibrierte Ultraschallwert ohne besonderen Aufwand auf eine andere Bond-Einrichtung reproduzierbar ist, und dadurch die elektrischen Schaltungen stets mit gleichen Ultraschallwerten gebondet werden können.

**Patentansprüche**

1. Verfahren zur Messung der Schwingungsamplitude an einem Energietransducer (25), welcher zusammen mit einer entsprechend ausgebildeten Bondkopf-Vorrichtung (50) zur Ultraschall kontaktierenden Drahtverbindung von elektrischen Schaltungen an metallenen Systemträgern dem jeweiligen Prozesspunkt zugestellt und zur Erzeugung einer mechanischen Longitudinal-Schwingung mit einem eingegebenen, ersten Ultraschallwert zur Erzeugung einer elektrischen Spannung beaufschlagt wird, wobei die momentane Amplitude der Longitudinal-Schwingung des Energietransducers (25) gemessen wird, dadurch gekennzeichnet, dass die vorgegebene Zustellbewegung der Bondkopf-Vorrichtung (50) gemessen wird, aus den derart ermittelten Messgrössen ein Korrekturfaktor ($K_f$) bestimmt wird, und mit dem Korrekturfaktor ($K_f$) der erste Ultraschallwert und dadurch die Schwingungsamplitude des Energietransducers (25) kalibriert wird.

2. Verfahren nach Anspruch 1, dadurch gekennzeichnet, dass einerseits die Longitudinal-Schwingung des Energietransducers (25) und andererseits die Zustellbewegung der Bondkopf-Vorrichtung (50) optisch/elektrisch gemessen und aus den Messgrössen eine zur Zustellbewegung proportionale, erste elektrische Spannung $U_k$ sowie eine zur Longitudinal-Schwingung proportionale, zweite elektrische Spannung $U_m$ erzeugt wird.

3. Verfahren nach den Ansprüchen 1 und 2, dadurch gekennzeichnet, dass
   a) die reale Zustellbewegung der Bondkopf-Vorrichtung (50) als Wegstrecke ($S_k$) gemessen und diese in die erste, elektrische Spannung $U_k$ umgewandelt und gespeichert wird;
   b) die momentane Longitudinal-Schwingungsamplitude des Energietransducers (25) als erste Messgrösse $S_m$ gemessen und diese in die zweite, elektrische Spannung $U_m$ umgewandeltund gespeichert wird;
   c) eine rechnerische Bestimmung der Ultraschall-Amplitude
   ($S'_m$) gemäss folgender Gleichung durchgeführt wird;

$$S'_m = S_k \ \frac{U_m}{U_k}$$

   und dass
   d) die derart ermittelte Ultraschall-Amplitude ($S'_m$) als Korrekturfaktor ($K_f$) umgewandelt wird.

4. Verfahren nach Anspruch 1, dadurch gekennzeichnet, dass der erste Ultraschallwert mit dem rechnerisch bestimmten Korrekturfaktor ($K_f$) multipliziert wird.

5. Verfahren nach einem der Ansprüche 1 bis 4, dadurch gekennzeichnet, dass bei unterbrochenem Bondvorgang und in bestimmten Zeitabständen, vorzugsweise in regelmässigen Zeitabständen die Ultraschall-Amplitude ($S'_m$) rechnerisch bestimmt und in den Korrekturfaktor ($K_f$) umgewandelt wird, wobei mit diesem Korrekturfaktor ($K_f$) der erste Ultraschallwert multipliziert wird.

6. Verfahren nach Anspruch 3, dadurch gekennzeichnet, dass die Bondkopf-Vorrichtung (50) mit einer einer mehrfachen, vorzugsweise einer zehnfachen der Grösse der Ultraschallamplitude entsprechenden Wegstrecke verstellt wird, und dass diese Wegstrecke ($S_k$) gemessen und in die erste elektrische Spannung ($U_k$) umgewandelt wird.

7. Einrichtung (100) zur Durchführung des Verfahrens nach Anspruch 1, bestehend aus einem Trägerelement (60) mit einer Auflageplatte (47) für einen metallenen Systemträger (46) und einer Bondkopf-Vorrichtung (50), welche zusammen mit dem daran angeordneten Energietransducer (25) zum Bonden elektrischer Schaltungen dem jeweiligen Prozesspunkt (P) des Systemträgers zustellbar ist, dadurch gekennzeichnet, dass ein entsprechend angeordneter und mit einem Rechner (200) in Wirkverbindung stehender Messkopf (55) mit mindestens einem optisch/elektrischen Sensor (52) vorgesehen ist, und dass der Sensor (52) einen optischen Wirkungsbereich aufweist, mit welchem sowohl eine Wegstrecke ($S_k$) für die Zustellbewegung der Bondkopf-Vorrichtung (50) als auch eine Messgrösse ($S_m$) für die Longitudinal-Schwingung des Energietransducers (25) erfassbar und mit den Messwerten der Rechner (200) aktivierbar ist.

8. Einrichtung nach Anspruch 7, dadurch gekennzeichnet, dass der Messkopf (55) in bezug zu der zustellbaren Bondkopf-Vorrichtung (50) feststehend an dem als Maschinenbasis ausgebildeten Trägerelement (60) befestigt ist.

5

9. Einrichtung nach Anspruch 7, dadurch gekennzeichnet, dass der Messkopf (55) eine Ausnehmung (51) mit zwei im Abstand zueinander angeordneten Wände (51',51'') zur Aufnahme eines Senderteils (52') und Empfängerteils (52'') des Sensors (52) aufweist, wobei die Ausnehmung (51) zur Aufnahme der an dem entsprechend bewegbaren dem Energietransducer (25) angeordneten Kapillare ausgebildet und dimensioniert ist.

10. Einrichtung nach Anspruch 7, dadurch gekennzeichnet, dass der Rechner (200)
   a) zur Erreichung der Zustellbewegung der Bondkopf-Vorrichtung (50) und zur Beaufschlagung des Energietransducers (25) mit einem ersten Ultraschallwert eine Steuereinheit (201), einen Multiplikator (202) sowie einen Generator (203) umfasst, und
   b) mit einem Verstärker (204) versehen ist, in welchem die Wegstrecke ($S_k$) der Bondkopf-Vorrichtung (50) in die erste, elektrische Spannung ($U_k$) und die Messgrösse ($S_m$) der Longitudinal-Schwingungsamplitude in die zweite, elektrische Spannung ($U_m$) umgewandelt wird; und
   c) einen ersten Prozessor (205) mit Mitteln zur rechnerischen Bestimmung der momentanen Ultraschall-Amplitude ($S'_m$) sowie einen zweiten Prozessor (206) mit Mitteln zur Umwandlung der momentanen Ultraschall-Amplitude ($S'_m$) in einen Korrekturfaktor ($K_f$) umfasst, mit welchem Korrekturfaktor ($K_f$) der erste Ultraschallwert im Multiplikator (202) multiplizierbar ist.

## Claims

1. Process for measuring the oscillation amplitude on an energy transducer (25) which, together with a suitably constructed bonding head device (50) for the ultrasound-bonding wire connection of electrical circuits to metal system carriers, is delivered to the respective processing point and, in order to generate a mechanical longitudinal oscillation, is acted upon by an input first ultrasound value in order to generate an electrical voltage, the instantaneous amplitude of the longitudinal oscillation of the energy transducer (25) being measured, characterized in that the predetermined delivery movement of the bonding head device (50) is measured, a correction factor ($K_f$) is determined from the measured variables determined in this manner and the first ultrasound value and thus the oscillation amplitude of the energy transducer (25) are calibrated with the correction factor ($K_f$).

2. Process according to Claim 1, characterized in that on the one hand the longitudinal oscillation of the energy transducer (25) and on the other the delivery movement of the bonding head device (50) are measured optically/electrically and a first electrical voltage $U_k$ proportional to the delivery movement and a second electrical voltage $U_m$ proportional to the longitudinal oscillation are generated from the measured variables.

3. Process according to Claims 1 and 2, characterized in that:
   a) the actual delivery movement of the bonding head device (50) is measured as a distance ($S_k$) which is converted into the first electrical voltage $U_k$ and is stored;
   b) the instantaneous longitudinal oscillation amplitude of the energy transducer (25) is measured as the first measured variable ($S_m$) which is converted into the second electrical voltage ($U_m$) and is stored;
   c) the ultrasound amplitude ($S'_m$) is determined by computer according to the following equation:

$$S'_m = S_k \frac{U_m}{U_k}$$

   and in that
   d) the ultrasound amplitude ($S'_m$) determined in this way is converted as a correction factor ($K_f$).

4. Process according to Claim 1, characterized in that the first ultrasound value is multiplied by the correction factor ($K_f$) determined by computer.

5. Process according to any one of Claims 1 to 4, characterized in that when the bonding process is interrupted and at given time intervals, preferably at regular time intervals, the ultrasound amplitude

(S'$_m$) is determined by computer and converted into the correction factor (K$_f$), the first ultrasound value being multiplied by this correction factor (K$_f$).

6. Process according to Claim 3, characterized in that the bonding head device (50) is displaced by a distance corresponding to a multiple, preferably ten times the size, of the ultrasound amplitude; and in that this distance (S$_k$) is measured and converted into the first electrical voltage (U$_k$).

7. Device (100) for performing the process according to Claim 1, consisting of a carrier component (60) having a supporting plate (47) for a metal system carrier (46) and a bonding head device (50) which, together with the energy transducer (25) disposed thereon, can be delivered to the respective processing point (P) of the system carrier for bonding electrical circuits, characterized in that a correspondingly disposed measuring head (55) which is operationally connected to a computer (200) is provided with at least one optical/electrical sensor (52); and in that the sensor (52) comprises an optical range of action by means of which both a distance (S$_k$) for the delivery movement of the bonding head device (50) and a measured variable (S$_m$) for the longitudinal oscillation of the energy transducer (25) can be detected and activated by the measured values of the computer (200).

8. Device according to Claim 7, characterized in that the measuring head (55) is secured on the carrier component (60), which is constructed as the machine base, in a manner such that it is stationary relative to the bonding head device (50) which can be delivered.

9. Device according to Claim 7, characterized in that the measuring head (55) has a recess (51) with two walls (51', 51'') disposed at a spacing from each other for accommodating a transmitter part (52') and a receiver part (52'') of the sensor (52), the recess (51) being constructed and dimensioned for accommodating the capillary tube disposed on the correspondingly movable energy transducer (25).

10. Device according to Claim 7, characterized in that the computer (200):
    a) comprises a control unit (201), a multiplier (202) and a generator (203) for achieving the delivery movement of the bonding head device (50) and for acting upon the energy transducer (25) with a first ultrasound value; and
    b) is provided with an amplifier (204) in which the distance (S$_k$) of the bonding head device (50) is converted into the first electrical voltage (U$_k$) and the measured variable (S$_m$) of the longitudinal oscillation amplitude is converted into the second electrical voltage (U$_m$); and
    c) comprises a first processor (205) with means for determining the instantaneous ultrasound amplitude (S'$_m$) by computer and a second processor (206) with means for converting the instantaneous ultrasound amplitude (S'$_m$) into a correction factor (K$_f$) by which correction factor (K$_f$) the first ultrasound value can be multiplied in the multiplier (202).

**Revendications**

1. Procédé de mesure de l'amplitude d'oscillation d'un transducteur d'énergie (25), qui avec un dispositif à tête de bonding (50), conçu en conséquence, est approché du point de processus respectif, en vue de la liaison de contact, par fil , par ultrasons, entre des circuits électriques et des supports de système-métalliques, et qui, pour produire une oscillation longitudinale mécanique, reçoit une première valeur d'ultrasons saisie , afin de produire une tension électrique, l'amplitude momentanée de l'oscillation longitudinale du transducteur d'énergie (25) étant mesurée, caractérisé en ce que l'approche donnée du dispositif à tête de bonding (50) est mesurée, en ce qu'un facteur de correction (K$_f$) est déterminé à partir des grandeurs mesurées ainsi obtenues, et la première valeur d'ultrasons est calibrée avec le facteur de correction (K$_f$) et, de ce fait, l'amplitude d'oscillation du transducteur d'énergie (25) est calibrée.

2. Procédé selon la revendication 1, caractérisé en ce que d'une part l'oscillation longitudinale du transducteur d'énergie (25) et d'autre part le mouvement d'approche du dispositif à tête de bonding (50) sont mesurés optiquement/électriquement et à partir des grandeurs mesurées il est produit une première tension électrique (U$_k$), proportionnelle au déplacement d'approche ainsi qu'une seconde tension électrique (U$_m$), proportionnelle à l'oscillation longitudinale.

3. Procédé selon les revendications 1 et 2, caractérisé en ce que

a) le déplacement d'approche réel du dispositif à tête de bonding (50) est mesuré en tant que distance ($S_k$) et celui-ci est converti dans la première tension électrique ($U_k$) et mémorisé ;

b) l'amplitude d'oscillation longitudinale momentanée du transducteur d'énergie (25) est mesurée en tant que première grandeur de mesure ($S_m$) et celle-ci est convertie dans la seconde tension électrique ($U_m$) et mémorisée ;

c) il est procédé à un calcul par ordinateur de l'amplitude d'ultrasons (S'm) selon l'équation suivante ;

$$S'_m = S_k \frac{U_m}{U_k}$$

et en ce que

d) l'amplitude d'ultrasons ($S'_m$) ainsi déterminée est convertie en facteur de correction ($K_f$).

4. Procédé selon la revendication 1, caractérisé en ce que la première valeur d'ultrasons est multipliée par le facteur de correction ($K_f$), obtenu par calcul.

5. Procédé selon l'une des revendications 1 à 4, caractérisé en ce que dans le cas d'une interruption de l'opération de bonding et à intervalles de temps déterminés, de préférence à intervalles de temps réguliers, l'amplitude d'ultrasons ($S'_m$) est déterminée par ordinateur et convertie dans le facteur de correction ($K_f$), la première valeur d'ultrasons étant multipliée par ce facteur de correction ($K_f$).

6. Procédé selon la revendication 3, caractérisé en ce que le dispositif à tête de bonding (50) est déplacé sur une distance correspondant à un multiple, de préférence à dix fois la grandeur de l'amplitude d'ultrasons, et en ce que cette distance ($S_k$) est mesurée et convertie dans la première tension électrique ($U_k$).

7. Dispositif (100) pour la mise en oeuvre du procédé selon la revendication 1, constitué d'un élément de support (60) avec une plaque d'appui (47) pour un support de système (46) métallique et un dispositif à tête de bonding (50), qui avec le transducteur d'énergie (25) placé sur celui-ci peut être approché, en vue du bonding de circuits électriques, du point de processus (P) respectif du support de système, caractérisé en ce qu'il est prévu une tête de mesure (55) montée en conséquence et en liaison active avec un ordinateur (200), avec au moins un capteur (52) optique/électrique, et en ce que le capteur (52) présente une plage d'action optique, avec laquelle une distance ($S_k$) pour le déplacement d'approche du dispositif à tête de bonding (50) ainsi qu'une grandeur de mesure ($S_m$) pour l'oscillation longitudinale du transducteur d'énergie (25) peuvent être détectées et en ce que l'ordinateur (200) peut être activé avec les valeurs mesurées.

8. Dispositif selon la revendication 7, caractérisé en ce que la tête de mesure (55) est fixée par rapport au dispositif à tête de bonding (50) ajustable, sur l'élément de support (60), conçu en tant que base de la machine.

9. Dispositif selon la revendication 7, caractérisé en ce que la tête de mesure (55) présente un évidement (51) avec deux parois (51', 51''), espacées l'une de l'autre, destiné à recevoir un élément émetteur (52') et un élément récepteur (52'') du capteur (52), l'évidement (51) étant conçu et dimensionné pour recevoir les capillaires placés sur le transducteur d'énergie (25), déplaçables en conséquence.

10. Dispositif selon la revendication 7, caractérisé en ce que l'ordinateur (200)

a) comporte une unité de commande (201), un multiplicateur (202) ainsi qu'un générateur (203), en vue d'obtenir le mouvement d'approche du dispositif à tête de bonding (50) et en vue d'envoyer au transducteur d'énergie (25) une première valeur d'ultrasons, et

b) est doté d'un amplificateur (204), dans lequel la distance ($S_k$) du dispositif à tête de bonding (50), est convertie dans la première tension électrique ($U_k$) et la grandeur de mesure ($S_m$) de l'amplitude d'oscillation longitudinale, est convertie dans la seconde tension électrique ($U_m$) ;

c) comporte un premier processeur (205) avec des moyens de détermination par ordinateur de l'amplitude d'ultrasons momentanée ($S'_m$) ainsi qu'un second processeur (206) avec des moyens de conversion de l'amplitude d'ultrasons momentanée ($S'_m$) dans un facteur de correction ($K_f$), la première valeur d'ultrasons pouvant être multipliée dans le multiplicateur (202) avec ce facteur de correction ($K_f$).

FIG.1

EP 0 498 936 B1

FIG. 2

EP 0 498 936 B1